# EUROPEAN PATENT SPECIFICATION

(11) **EP 3 856 858 B1**
(45) Date of publication and mention of the grant of the patent: **04.11.2026**
(21) Application number: 19783864.2
(22) Date of filing: 25.09.2019
(51) Int. Cl.: C09D 11/104, C09D 11/106, C09D 11/107, C09D 11/108, C09D 11/52, B42D 25/00, C09D 11/102

(54) **ELECTRICALLY SHIELDED ARTICLE**
ELEKTRISCH ABGESCHIRMTER GEGENSTAND
ARTICLE BLINDÉ ÉLECTRIQUEMENT

(30) Priority: 28.09.2018 US 201862738089 P; 01.04.2019 US 201962827560 P; 04.04.2019 US 201962829403 P; 03.06.2019 US 201962856306 P; 20.09.2019 US 201916576872
(43) Date of publication of application: 04.08.2021
(73) Proprietor: PPG Industries Ohio Inc., Cleveland, OH 44111 (US)
(72) Inventor: BOYER, James L., Keyser, West Virginia 26726 (US); DEBERRY, Shawn, R., Cranberry Township, Pennsylvania 16066 (US); HAHN, Michael, W., Medina, Ohio 44256 (US); HAWKE, Logan, T., Tarentum, Pennsylvania 15084 (US); SIUDA, Ewa, Allison Park, Pennsylvania 15101 (US)
(74) Representative: f & e patent
(86) International application number: PCT/US2019/052818
(87) International publication number: WO 2020/068893

(56) References cited:
- EP-A1- 1 860 163
- WO-A1-2017/114978
- US-A1- 2007 205 953
- US-A1- 2009 246 487
- US-B1- 6 537 359

## Description

### CROSS REFERENCE TO RELATED APPLICATIONS

This application claims priority to United States Patent Application Serial No. 16/576,872, filed September 20, 2019, United States Provisional Patent Application Serial No. 62/856,306, filed on June 3, 2019, United States Provisional Patent Application Serial No. 62/829,403, filed on April 4, 2019, United States Provisional Patent Application Serial No. 62/827,560, filed on April 1, 2019, and United States Provisional Patent Application Serial No. 62/738,089, filed on September 28, 2018.

### FIELD OF THE INVENTION

The present invention relates to an electrically shielded article and a method of preparing the same.

### BACKGROUND OF THE INVENTION

Radio frequency (RF) communication enables data to be communicated from a transmitter, such as an RF-actuated chip, to a receiver. Articles and devices across various fields utilize radio frequency communication to communicate data by including an RF-actuated chip in the article or device itself, such that certain receives are capable of receiving the data stored thereon.

As one example, passports (and other identification devices) commonly include an RF-actuated chip including data associated with the user to whom the passport has been issued. Though enabling the user identity to be verified more efficiently, leading to more efficient travel, certain of the data stored on the RF-actuated chip may be sensitive or confidential personal information. However, an identity thief with suitable electronic equipment (e.g., an RF receiver) may have the capability to read and/or write from or to the RF-actuated chip in the user's passport, thus potentially compromising the sensitive or confidential personal information.

Similar concerns arise with respect to data communicated over other wavelengths in the electromagnetic spectrum, such as in the microwave range, the long radio wave range, and the like.

US 6,537,359 B1 relates to relates to a deformable, electrically conductive ink or paint comprising electrically conductive particles, a binding agent and a solvent, which can be used for providing an electromagnetic shielding layer on a substrate.

US 2007/0205953 A1 relates to machine readable passports with an electromagnetic shield capable of selectively disrupting wireless communication with a passport-integrated microcontroller when the passport is closed, and enable it when the document is opened. The electromagnetic shield may for example be implemented by printing a conductive ink as a continuous film or as a mesh.

WO 2017/114978 A1 relates to a piezoresistive ink composition for production of piezoresistive sensors. The ink can change linearly electrical resistivity with an applied deformation and recover when the external applied strass is released. The ink composition comprises a thermoplastic elastomer polymer, conductive nanostructures of carbon or metal (i.e. a conductive material), and certain kinds of solvent and dispersing agents.

EP 1 860 163 A1 relates to an electrically conductive ink and electrically conductive circuits formed therefrom on a substrate. The electrically conductive ink comprises an electrically conductive material (e.g. metal particles) and a vinyl chloride/vinyl acetate/hydroxyalkyl (meth)acrylate copolymer resin.

US 2009/0246487 A1 relates to microporous materials suitable as substrates for printed electronics and electronic devices making use thereof. The microporous material comprises a polyolefin matrix, a finely divided filler distributed throughout the matrix and a network of interconnected pores.

### SUMMARY OF THE INVENTION

The present invention is directed to an electrically shielded article as defined in appended independent claim 1. Some more specific forms of the electrically shielded article are subject of appended dependent claims 2 to 9. The electrically shielded article includes: a flexible and/or elongatable substrate; and a conductive ink applied over at least a portion of the substrate, the conductive ink including a resin and a conductive material. When the conductive ink is applied over the substrate, the conductive material in the conductive ink is present over the substrate in an amount of at least 5 g/m². The electrically shielded article exhibits a signal loss of at least 5 dBm at up to 4 mm according to the NFC Detuning Test.

The present invention is also directed to a method of preparing an electrically shielded article as defined in appended independent claim 10. A more specific form of the method is subject of appended dependent claim 11. The method includes applying a conductive ink to a flexible and/or elongatable substrate. The conductive ink includes a resin and a conductive material. When the conductive ink is applied over the substrate, the conductive material in the conductive ink is present over the substrate in an amount of at least 5 g/m². The electrically shielded article provides a signal loss of at least 5 dBm at up to 4 mm according to the NFC Detuning Test.

The present invention also concerns an identification device as defined in appended independent claim 12. A more specific form of the identification device is subject of appended dependent claim 13.

### BRIEF DESCRIPTION OF THE DRAWINGS

FIG. 1A shows an electrically shielded article in which a conductive ink has been applied over a substrate in a grid pattern;
FIG. 1B shows an electrically shielded article in which a conductive ink has been applied over a substrate by flood coating;
FIG. 2 shows an electrically shielded article;
FIG. 3 shows an identification device (e.g., a passport) including an electrically shielded article;
FIG. 4 shows a graph of signal loss at various frequencies for Samples 1, 5, and 6 of the Examples;
FIG. 5 shows a graph of detuning at several gap distances for Sample 4;
FIGS. 6A and 6B show graphs of signal loss and detuned resonance frequency, respectively, over gap distance for Samples 2, 6, and a control copper sheet;
FIG. 7 shows a graph of signal loss as a function of % elongation for Sample 4;
FIGS. 8A and 8B show graphs of resistance as a function of % elongation measured in the cross direction and machine direction, respectively;
FIG. 9 shows a box sealed with electrically shielding tape (an example of an electrically shielded article);
FIG. 10 shows a space having electrically shielding wallpaper (an example of an electrically shielded article) on the walls and/or ceiling, forming an electrically shielded room;
FIG. 11 shows a wallet for carrying electronic payment cards, the wallet including an electrically shielded article; and
FIG. 12 shows a roll of an electrically shielded article, such as electrically shielding tape, electrically shielding paper, and the like.

### DETAILED DESCRIPTION OF THE INVENTION

For the purposes of the following detailed description, it is to be understood that the invention may assume various alternative variations and step sequences, except where expressly specified to the contrary. Moreover, other than in any operating examples, or where otherwise indicated, all numbers expressing, for example, quantities of ingredients used in the specification and claims are to be understood as being modified in all instances by the term "about". Accordingly, unless indicated to the contrary, the numerical parameters set forth in the following specification and attached claims are approximations that may vary depending upon the desired properties to be obtained by the present invention. At the very least, and not as an attempt to limit the application of the doctrine of equivalents to the scope of the claims, each numerical parameter should at least be construed in light of the number of reported significant digits and by applying ordinary rounding techniques.

Notwithstanding that the numerical ranges and parameters setting forth the broad scope of the invention are approximations, the numerical values set forth in the specific examples are reported as precisely as possible. Any numerical value, however, inherently contain certain errors necessarily resulting from the standard deviation found in their respective testing measurements.

Also, it should be understood that any numerical range recited herein is intended to include all sub-ranges subsumed therein. For example, a range of "1 to 10" is intended to include all sub-ranges between (and including) the recited minimum value of 1 and the recited maximum value of 10, that is, having a minimum value equal to or greater than 1 and a maximum value of equal to or less than 10.

As used herein, the articles "a", "an", and "the" include plural referents, unless expressly and unequivocally limited to one referent.

As used herein, the transitional term "comprising" (and other comparable terms, *e.g.,* "containing" and "including") is "open-ended" and open to the inclusion of unspecified matter. Although described in terms of "comprising", the terms "consisting essentially of" and "consisting of" are also within the scope of the invention.

As used herein, the term "electrically shielded article" refers to an article that is capable of providing electrical shielding to itself or some other item by way of the functionality of the article or a component of the article.

The present disclosure is directed to an electrically shielded article, comprising: a flexible and/or elongatable substrate; and a conductive ink applied over the substrate, the conductive ink comprising a resin and a conductive material, wherein when the conductive ink is applied over the substrate, the conductive material in the conductive ink is present over the substrate in an amount of at least 5 g/m², wherein the electrically shielded article exhibits a signal loss of at least 5 dBm at up to 4 mm according to the NFC Detuning Test.

The electrically shielded article may provide electrical shielding at frequency ranges falling within at least one of the following ranges in the electromagnetic spectrum: ultraviolet, visible light, infrared, microwave, radio wave (including long radio waves). The electrically shielded article may provide electrical shielding within the microwave and/or radio wave (including long radio waves) range. These various ranges are defined as follows:

| **Region** | **Wavelength Range** |
|---|---|
| Ultraviolet | 1 nm-400 nm |
| Visible Light | 400 nm-750 nm |
| Infrared | 750 nm-25 µm |
| Microwave | 25 µm-1 mm |
| Radio Wave | > 1 mm |

The substrate is flexible and/or elongatable. The substrate may be elongatable by at least 10%, such as at least 50%, such as at least 100% compared to its original length and/or width. The substrate may be elongatable by from 10%-1000%, such as 50%-1000%, such as from 100%-1000% compared to its original length and/or width. The substrate includes a polyolefin. The substrate may include a Teslin^{®} membrane (available from PPG Industries, Inc. (Pittsburgh, PA)). The substrate may include RhinoHide^{®} separators (available from Entek (Lebanon, OR)) or Daramic^{®} separators (available from Polypore International, LP (Charlotte, NC)).

The substrate may comprise pores. The substrate may include a microporous material.

As used herein, "microporous material" or "microporous sheet" means a material having a network of interconnecting pores, wherein, on a treatment-free, coating-free, printing ink-free, impregnant-free, and pre-bonding basis, the pores have a volume average diameter ranging from 0.001 to 1.0 micrometer, and constitute at least 5 percent by volume of the microporous material as discussed herein below.

The polyolefinic polymeric matrix can comprise any of a number of known polyolefinic materials known in the art. In some instances, a different polymer derived from at least one ethylenically unsaturated monomer may be used in combination with the polyolefinic polymers. Suitable examples of such polyolefinic polymers can include, but are not limited to, polymers derived from ethylene, propylene, and/or butene, such as polyethylene, polypropylene, and polybutene. High density and/or ultrahigh molecular weight polyolefins, such as high density polyethylene, are also suitable. The polyolefin matrix also can comprise a copolymer, for example, a copolymer of ethylene and butene or a copolymer of ethylene and propylene.

Non-limiting examples of ultrahigh molecular weight (UHMW) polyolefin can include essentially linear UHMW polyethylene (PE) or polypropylene (PP). Inasmuch as UHMW polyolefins are not thermoset polymers having an infinite molecular weight, they are technically classified as thermoplastic materials.

The ultrahigh molecular weight polyethylene can comprise essentially linear ultrahigh molecular weight isotactic polyethylene. Often, the degree of isotacticity of such polymer is at least 95 percent, e.g., at least 98 percent.

While there is no particular restriction on the upper limit of the intrinsic viscosity of the UHMW polyethylene, in one non-limiting example, the intrinsic viscosity can range from 18 to 39 deciliters/gram, e.g., from 18 to 32 deciliters/gram. While there is no particular restriction on the upper limit of the intrinsic viscosity of the UHMW polypropylene, in one non-limiting example, the intrinsic viscosity can range from 6 to 18 deciliters/gram, e.g., from 7 to 16 deciliters/gram.

For purposes of the present invention, intrinsic viscosity is determined by extrapolating to zero concentration the reduced viscosities or the inherent viscosities of several dilute solutions of the UHMW polyolefin where the solvent is freshly distilled decahydronaphthalene to which 0.2 percent by weight, 3,5-di-tert-butyl-4-hydroxyhydrocinnamic acid, neopentanetetrayl ester [CAS Registry No. 6683-19-8] has been added. The reduced viscosities or the inherent viscosities of the UHMW polyolefin are ascertained from relative viscosities obtained at 135°C using an Ubbelohde No. 1 viscometer in accordance with the general procedures of ASTM D 4020-81, except that several dilute solutions of differing concentration are employed.

The nominal molecular weight of UHMW polyethylene is empirically related to the intrinsic viscosity of the polymer in accordance with the following equation: 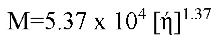 wherein M is the nominal molecular weight and [ή] is the intrinsic viscosity of the UHMW polyethylene expressed in deciliters/gram. Similarly, the nominal molecular weight of UHMW polypropylene is empirically related to the intrinsic viscosity of the polymer according to the following equation: 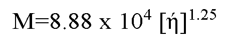 wherein M is the nominal molecular weight and [ή] is the intrinsic viscosity of the UHMW polypropylene expressed in deciliters/gram.

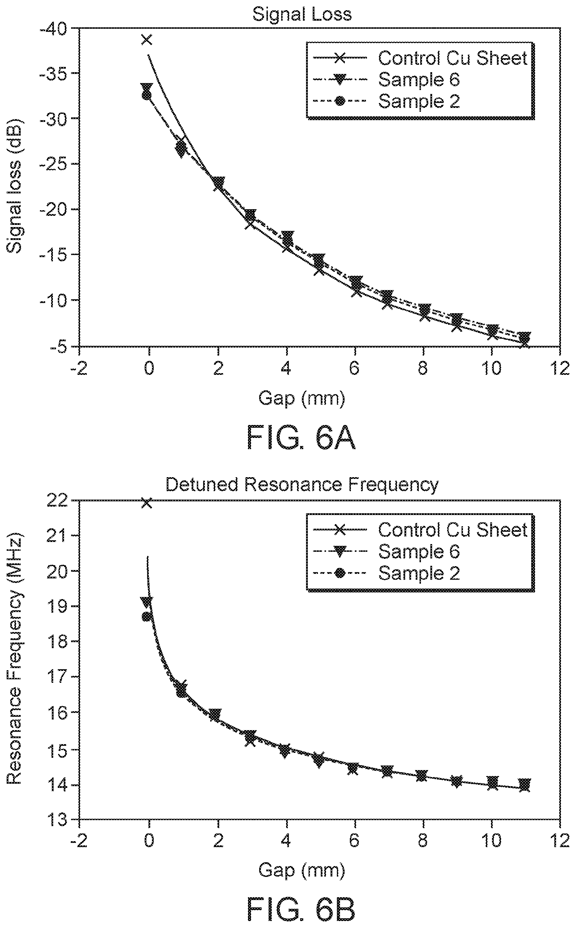

A mixture of substantially linear ultrahigh molecular weight polyethylene and lower molecular weight polyethylene can be used. The UHMW polyethylene may have an intrinsic viscosity of at least 10 deciliters/gram, and the lower molecular weight polyethylene has an ASTM D 1238-86 Condition E melt index of less than 50 grams/10 minutes, e.g., less than 25 grams/10 minutes, such as less than 15 grams/10 minutes, and an ASTM D 1238-86 Condition F melt index of at least 0.1 gram/10 minutes, e.g., at least 0.5 gram/10 minutes, such as at least 1.0 gram/10 minutes. The amount of UHMW polyethylene used (as weight percent) in this example is described in column 1, line 52 to column 2, line 18 of U.S. Patent No. 5,196,262. More particularly, the weight percent of UHMW polyethylene used is described in relation to Figure 6 of U.S. Patent No. 5,196,262; namely, with reference to the polygons ABCDEF, GHCI or JHCK of Figure 6.

The nominal molecular weight of the lower molecular weight polyethylene (LMWPE) is lower than that of the UHMW polyethylene. LMWPE is a thermoplastic material and many different types are known. One method of classification is by density, expressed in grams/cubic centimeter and rounded to the nearest thousandth, in accordance with ASTM D 1248-84 (Reapproved 1989). Non-limiting examples of the densities are found in the following table.

| Type | Abbreviation | Density, g/cm³ |
|---|---|---|
| Low Density PE | LDPE | 0.910-0.925 |
| Medium Density PE | MDPE | 0.926-0.940 |
| High Density PE | HDPE | 0.941-0.965 |

Any or all of the polyethylenes listed in the table above may be used as the LMWPE in the matrix of the microporous material. HDPE may be used because it can be more linear than MDPE or LDPE. Processes for making the various LMWPE's are well known and well documented. They include the high-pressure process, the Phillips Petroleum Company process, the Standard Oil Company (Indiana) process, and the Ziegler process. The ASTM D 1238-86 Condition E (that is, 190°C and 2.16 kilogram load) melt index of the LMWPE is less than 50 grams/10 minutes. Often, the Condition E melt index is less than 25 grams/10 minutes. The Condition E melt index can be less than 15 grams/10 minutes. The ASTM D 1238-86 Condition F (that is, 190°C and 21.6 kilogram load) melt index of the LMWPE is at least 0.1 gram/10 minutes. In many cases, the Condition F melt index is at least 0.5 gram/10 minutes, such as at least 1.0 gram/10 minutes.

The UHMWPE and the LMWPE may together constitute at least 65 percent by weight, e.g., at least 85 percent by weight, of the polyolefin polymer of the microporous material. Also, the UHMWPE and LMWPE together may constitute substantially 100 percent by weight of the polyolefin polymer of the microporous material.

The polyolefinic polymeric matrix can comprise a polyolefin comprising ultrahigh molecular weight polyethylene, ultrahigh molecular weight polypropylene, high density polyethylene, high density polypropylene, or mixtures thereof.

If desired, other thermoplastic organic polymers also may be present in the matrix of the microporous material provided that their presence does not materially affect the properties of the microporous material substrate in an adverse manner. The amount of the other thermoplastic polymer which may be present depends upon the nature of such polymer. Non-limiting examples of thermoplastic organic polymers that optionally may be present in the matrix of the microporous material include low density polyethylene, high density polyethylene, poly(tetrafluoroethylene), polypropylene, copolymers of ethylene and propylene, copolymers of ethylene and acrylic acid, and copolymers of ethylene and methacrylic acid. If desired, all or a portion of the carboxyl groups of carboxyl-containing copolymers can be neutralized with sodium, zinc, or the like. Generally, the microporous material comprises at least 40 percent by weight of UHMW polyolefin, based on the weight of the matrix. The above-described other thermoplastic organic polymer may be substantially absent from the matrix of the microporous material.

The microporous material may further include finely divided, particulate, substantially water-insoluble inorganic filler distributed throughout the matrix.

The inorganic filler may include any of a number of inorganic fillers known in the art. The filler should be finely divided and substantially water insoluble to permit uniform distribution throughout the polyolefinic polymeric matrix during manufacture of the microporous material. Generally, the inorganic filler is selected from the group consisting of silica, alumina, calcium oxide, zinc oxide, magnesium oxide, titanium oxide, zirconium oxide, and mixtures thereof.

The finely divided substantially water-insoluble filler may be in the form of ultimate particles, aggregates of ultimate particles, or a combination of both. At least 90 percent by weight of the filler used in preparing the microporous material has gross particle sizes in the range of from 5 to 40 micrometers, as determined by the use of a laser diffraction particle size instrument, LS230 from Beckman Coulton, capable of measuring particle diameters as small as 0.04 micron. Typically, at least 90 percent by weight of the filler has gross particle sizes in the range of from 10 to 30 micrometers. The sizes of the filler agglomerates may be reduced during processing of the ingredients used to prepare the microporous material. Accordingly, the distribution of gross particle sizes in the microporous material may be smaller than in the raw filler itself.

As mentioned previously, the filler particles may be substantially water-insoluble, and also can be substantially insoluble in any organic processing liquid used to prepare the microporous material. This can facilitate retention of the filler in the microporous material.

In addition to the fillers, other finely divided particulate substantially water-insoluble materials optionally may also be employed. Non-limiting examples of such optional materials can include carbon black, charcoal, graphite, iron oxide, copper oxide, antimony oxide, molybdenum disulfide, zinc sulfide, barium sulfate, strontium sulfate, calcium carbonate, and magnesium carbonate. The filler may be silica and/or any of the aforementioned optional filler materials.

The filler typically has a high surface area allowing the filler to carry much of the processing plasticizer used to form the microporous material. High surface area fillers are materials of very small particle size, materials that have a high degree of porosity, or materials that exhibit both characteristics. The surface area of the filler particles can range from 20 to 900 square meters per gram, e.g., from 25 to 850 square meters per gram, as determined by the Brunauer, Emmett, Teller (BET) method according to ASTM C 819-77 using nitrogen as the adsorbate but modified by outgassing the system and the sample for one hour at 130°C. Prior to nitrogen sorption, filler samples are dried by heating to 160°C in flowing nitrogen (PS) for 1 hour.

The inorganic filler may include a siliceous material, such as silica, such as precipitated silica, silica gel, or fumed silica.

Silica gel is generally produced commercially by acidifying an aqueous solution of a soluble metal silicate, e.g., sodium silicate at low pH with acid. The acid employed is generally a strong mineral acid, such as sulfuric acid or hydrochloric acid, although carbon dioxide can be used. Inasmuch as there is essentially no difference in density between the gel phase and the surrounding liquid phase while the viscosity is low, the gel phase does not settle out, that is to say, it does not precipitate. Consequently, silica gel may be described as a non-precipitated, coherent, rigid, three-dimensional network of contiguous particles of colloidal amorphous silica. The state of subdivision ranges from large, solid masses to submicroscopic particles, and the degree of hydration from almost anhydrous silica to soft gelatinous masses containing on the order of 100 parts of water per part of silica by weight.

Precipitated silica generally is produced commercially by combining an aqueous solution of a soluble metal silicate, ordinarily alkali metal silicate such as sodium silicate, and an acid so that colloidal particles of silica will grow in a weakly alkaline solution and be coagulated by the alkali metal ions of the resulting soluble alkali metal salt. Various acids may be used, including but not limited to mineral acids. Non-limiting examples of acids that can be used include hydrochloric acid and sulfuric acid, but carbon dioxide can also be used to produce precipitated silica. In the absence of a coagulant, silica is not precipitated from solution at any pH. The coagulant used to effect precipitation of silica may be the soluble alkali metal salt produced during formation of the colloidal silica particles, or it may be an added electrolyte, such as a soluble inorganic or organic salt, or it may be a combination of both.

Precipitated silica can be described as precipitated aggregates of ultimate particles of colloidal amorphous silica that have not at any point existed as macroscopic gel during the preparation. The sizes of the aggregates and the degree of hydration may vary widely. Precipitated silica powders differ from silica gels that have been pulverized in that the precipitated silica powders generally have a more open structure, that is, a higher specific pore volume. However, the specific surface area of precipitated silica, as measured by the Brunauer, Emmet, Teller (BET) method using nitrogen as the adsorbate, is often lower than that of silica gel.

Many different precipitated silicas can be employed as the filler used to prepare the microporous material. Precipitated silicas are well-known commercial materials, and processes for producing them are described in detail in many United States patents, including U.S. Patent Nos. 2,940,830, 2,940,830, and 4,681,750. The average ultimate particle size (irrespective of whether or not the ultimate particles are agglomerated) of precipitated silicas used is generally less than 0.1 micrometer, e.g., less than 0.05 micrometer or less than 0.03 micrometer, as determined by transmission electron microscopy. Non-limiting examples of suitable precipitated silicas include those sold under the Hi-Sil^{®} tradename by PPG Industries, Inc. (Pittsburgh, PA).

The inorganic filler particles can constitute from 10 to 90 percent by weight of the microporous material. For example, such filler particles can constitute from 25 to 90 percent by weight of the microporous material, such as from 30 percent to 90 percent by weight of the microporous material, or from 40 to 90 percent by weight of the microporous material, or from 50 to 90 percent by weight of the microporous material, and even from 60 percent to 90 percent by weight of the microporous material. The filler typically is present in the microporous material in an amount ranging from 50 percent to 85 percent by weight of the microporous material. Often, the weight ratio of filler to polyolefin in the microporous material ranges from 0.5:1 to 10:1, such as 1.7:1 to 3.5:1. The weight ratio of filler to polyolefin in the microporous material may be greater than 4:1.

The microporous material may include a network of interconnecting pores communicating throughout the microporous material.

On a treatment-free, coating free, or impregnant-free basis, such pores can comprise at least 5 percent by volume, e.g., from 5 to 95 percent by volume, or from 15 to 95 percent by volume, or from 20 to 95 percent by volume, or from 25 to 95 percent by volume, or from 35 to 70 percent by volume of the microporous material. Often, the pores comprise at least 35 percent by volume, or even at least 45 percent by volume of the microporous material.

As used herein, the porosity (also known as void volume) of the microporous material, expressed as percent by volume, is determined according to the following equation: $Porosity = 100 \left[1-{d}_{1}{/ d}_{2}\right]$ wherein d₁ is the density of the sample, which is determined from the sample weight and the sample volume as ascertained from measurements of the sample dimensions, and d₂ is the density of the solid portion of the sample, which is determined from the sample weight and the volume of the solid portion of the sample. The volume of the solid portion of the sample is determined using a Quantachrome Stereopycnometer (Quantachrome Instruments (Boynton Beach, FL)) in accordance with the accompanying operating manual.

Porosity also can be measured using a Gurley Densometer, model 4340, manufactured by GPI Gurley Precision Instruments of Troy, New York. The porosity values reported are a measure of the rate of air flow through a sample or it's resistance to an air flow through the sample. The unit of measure for this method is a "Gurley second" and represents the time in seconds to pass 100 cc of air through a 2.54 cm (1 inch) square area using a pressure differential of 12.40 cm (4.88 inches) of water. Lower values equate to less air flow resistance (more air is allowed to pass freely). For purposes of the present invention, the measurements are completed using the procedure listed in the manual for MODEL 4340 Automatic Densometer.

The volume average diameter of the pores of the microporous material can be determined by mercury porosimetry using an Autopore III porosimeter (Micromeritics (Norcross, GA)) in accordance with the accompanying operating manual. The volume average pore radius for a single scan is automatically determined by the porosimeter. In operating the porosimeter, a scan is made in the high pressure range (from 138 kilopascals absolute to 227 megapascals absolute). If approximately 2 percent or less of the total intruded volume occurs at the low end (from 138 to 250 kilopascals absolute) of the high pressure range, the volume average pore diameter is taken as twice the volume average pore radius determined by the porosimeter. Otherwise, an additional scan is made in the low pressure range (from 7 to 165 kilopascals absolute) and the volume average pore diameter is calculated according to the equation: $d = 2 \left[{v}_{1}{r}_{1}{/ w}_{1}+{v}_{2}{r}_{2}{/ w}_{2}\right] / \left[{v}_{1}{/ w}_{1}+{v}_{2}{/ w}_{2}\right]$ wherein d is the volume average pore diameter, v₁ is the total volume of mercury intruded in the high pressure range, v₂ is the total volume of mercury intruded in the low pressure range, r₁ is the volume average pore radius determined from the high pressure scan, r₂ is the volume average pore radius determined from the low pressure scan, w₁ is the weight of the sample subjected to the high pressure scan, and w₂ is the weight of the sample subjected to the low pressure scan.

In the course of determining the volume average pore diameter of the above procedure, the maximum pore radius detected is sometimes noted. This is taken from the low pressure range scan, if run; otherwise, it is taken from the high pressure range scan. The maximum pore diameter is twice the maximum pore radius. Inasmuch as some production or treatment steps, e.g., coating processes, printing processes, impregnation processes and/or bonding processes, can result in the filling of at least some of the pores of the microporous material, and since some of these processes irreversibly compress the microporous material, the parameters in respect of porosity, volume average diameter of the pores, and maximum pore diameter are determined for the microporous material prior to the application of one or more of such production or treatment steps.

To prepare the microporous materials, filler, polyolefin polymer (typically in solid form such as powder or pellets), processing plasticizer, and minor amounts of lubricant and antioxidant may be mixed until a substantially uniform mixture is obtained. The weight ratio of filler to polymer employed in forming the mixture is essentially the same as that of the microporous material substrate to be produced. The mixture, together with additional processing plasticizer, is introduced to the heated barrel of a screw extruder. Attached to the extruder is a die, such as a sheeting die, to form the desired end shape.

In an exemplary manufacturing process, when the material is formed into a sheet or film, a continuous sheet or film formed by a die is forwarded to a pair of heated calendar rolls acting cooperatively to form a continuous sheet of lesser thickness than the continuous sheet exiting from the die. The final thickness may depend on the desired end-use application. The microporous material may have a thickness ranging from 0.7 to 18 mil (17.8 to 457.2 µm), such as 0.7 to 15 mil (17.8 to 381 µm), or 1 to 10 mil (25.4 to 254 µm), or 5 to 10 mil (127 to 254 µm), and demonstrates a bubble point of 7 to 552 kPa (1 to 80 psi) based on ethanol. For example, the microporous material may have a thickness of 6 mil (145 µm), 7 mil (178 µm), 8 mil (203 µm), 10 mil (254 µm), 12 mil (305 µm), 14 mil (356 µm), or 18 mil (457 µm).

Optionally, the sheet exiting the calendar rolls may then be stretched in at least one stretching direction above the elastic limit. Stretching may alternatively take place during or immediately after exiting from the sheeting die or during calendaring, or multiple times during the manufacturing process. Stretching may take place before extraction, after extraction, or both. Additionally, stretching may take place during the application of the first and/or second treatment compositions, described in more detail below. Stretched microporous material substrate may be produced by stretching the intermediate product in at least one stretching direction above the elastic limit. Usually, the stretch ratio is at least 1.1. In many cases, the stretch ratio is at least 1.5. Preferably, it is at least 2. Frequently, the stretch ratio is in the range of from 1.2 to 15. Often, the stretch ratio is in the range of from 1.5 to 10. Usually, the stretch ratio is in the range of from 2 to 6.

The temperatures at which stretching is accomplished may vary widely. Stretching may be accomplished at ambient room temperature, but usually elevated temperatures are employed. The intermediate product may be heated by any of a wide variety of techniques prior to, during, and/or after stretching. Examples of these techniques include radiative heating, such as that provided by electrically heated or gas fired infrared heaters; convective heating, such as that provided by recirculating hot air; and conductive heating, such as that provided by contact with heated rolls. The temperatures which are measured for temperature control purposes may vary according to the apparatus used and personal preference. For example, temperature-measuring devices may be placed to ascertain the temperatures of the surfaces of infrared heaters, the interiors of infrared heaters, the air temperatures of points between the infrared heaters and the intermediate product, the temperatures of circulating hot air at points within the apparatus, the temperature of hot air entering or leaving the apparatus, the temperatures of the surfaces of rolls used in the stretching process, the temperature of heat transfer fluid entering or leaving such rolls, or film surface temperatures. In general, the temperature or temperatures are controlled such that the intermediate product is stretched substantially evenly so that the variations, if any, in film thickness of the stretched microporous material are within acceptable limits and so that the amount of stretched microporous material outside of those limits is acceptably low. It will be apparent that the temperatures used for control purposes may or may not be close to those of the intermediate product itself since they depend upon the nature of the apparatus used, the locations of the temperature-measuring devices, and the identities of the substances or objects whose temperatures are being measured.

In view of the locations of the heating devices and the line speeds usually employed during stretching, gradients of varying temperatures may or may not be present through the thickness of the intermediate product. Also, because of such line speeds, it is impracticable to measure these temperature gradients. The presence of gradients of varying temperatures, when they occur, makes it unreasonable to refer to a singular film temperature. Accordingly, film surface temperatures, which can be measured, are best used for characterizing the thermal condition of the intermediate product.

These are ordinarily the same across the width of the intermediate product during stretching although they may be intentionally varied, as, for example, to compensate for intermediate product having a wedge-shaped cross section across the sheet. Film surface temperatures along the length of the sheet may be the same or they may be different during stretching.

The film surface temperatures at which stretching is accomplished may vary widely, but in general they are such that the intermediate product is stretched substantially evenly, as explained above. In most cases, the film surface temperatures during stretching are in the range of from 20°C to 220°C. Often, such temperatures are in the range of from 50°C to 200°C. From 75°C to 180°C is preferred.

Stretching may be accomplished in a single step or a plurality of steps as desired. For example, when the intermediate product is to be stretched in a single direction (uniaxial stretching), the stretching may be accomplished by a single stretching step or a sequence of stretching steps until the desired final stretch ratio is attained. Similarly, when the intermediate product is to be stretched in two directions (biaxial stretching), the stretching can be conducted by a single biaxial stretching step or a sequence of biaxial stretching steps until the desired final stretch ratios are attained. Biaxial stretching may also be accomplished by a sequence of one of more uniaxial stretching steps in one direction and one or more uniaxial stretching steps in another direction. Biaxial stretching steps where the intermediate product is stretched simultaneously in two directions and uniaxial stretching steps may be conducted in sequence in any order. Stretching in more than two directions is within contemplation. It may be seen that the various permutations of steps are quite numerous. Other steps, such as cooling, heating, sintering, annealing, reeling, unreeling, and the like, may optionally be included in the overall process as desired.

Various types of stretching apparatus are well known and may be used to accomplish stretching of the intermediate product. Uniaxial stretching is usually accomplished by stretching between two rollers, wherein the second or downstream roller rotates at a greater peripheral speed than the first or upstream roller. Uniaxial stretching can also be accomplished on a standard tentering machine. Biaxial stretching may be accomplished by simultaneously stretching in two different directions on a tentering machine. More commonly, however, biaxial stretching is accomplished by first uniaxially stretching between two differentially rotating rollers as described above, followed by either uniaxially stretching in a different direction using a tenter machine or by biaxially stretching using a tenter machine. The most common type of biaxial stretching is where the two stretching directions are approximately at right angles to each other. In most cases where the continuous sheet is being stretched, one stretching direction is at least approximately parallel to the long axis of the sheet (machine direction) and the other stretching direction is at least approximately perpendicular to the machine direction and is in the plane of the sheet (transverse direction).

Stretching the sheets prior to extraction of the processing plasticizer allows for thinner films with larger pore sizes than in microporous materials conventionally processed. It is also believed that stretching of the sheets prior to extraction of the processing plasticizer minimizes thermal shrinkage after processing. It also should be noted that stretching of the microporous material can be conducted at any point prior to, during, or subsequent to application of the first treatment composition (as described herein below), and/or prior to, during, or subsequent to application of the second treatment composition. Stretching of the microporous material can occur once or multiple times during the treatment process.

The product passes to a first extraction zone where the processing plasticizer is substantially removed by extraction with an organic liquid, which is a good solvent for the processing plasticizer, a poor solvent for the organic polymer, and more volatile than the processing plasticizer. Usually, but not necessarily, both the processing plasticizer and the organic extraction liquid are substantially immiscible with water. The product then passes to a second extraction zone where the residual organic extraction liquid is substantially removed by steam and/or water. The product is then passed through a forced air dryer for substantial removal of residual water and remaining residual organic extraction liquid. From the dryer, the microporous material may be passed to a take-up roll, when it is in the form of a sheet.

The processing plasticizer has little solvating effect on the thermoplastic organic polymer at 60°C, only a moderate solvating effect at elevated temperatures on the order of 100°C, and a significant solvating effect at elevated temperatures on the order of 200°C. It is a liquid at room temperature and usually it is processing oil, such as paraffinic oil, naphthenic oil, or aromatic oil. Suitable processing oils include those meeting the requirements of ASTM D 2226-82, Types 103 and 104. Those oils which have a pour point of less than 22°C, or less than 10°C, according to ASTM D 97-66 (reapproved 1978) are used most often. Examples of suitable oils include Shellflex^{®} 412 and Shellflex^{®} 371 oil (Shell Oil Company (Houston, TX)) which are solvent refined and hydrotreated oils derived from naphthenic crude. It is expected that other materials, including the phthalate ester plasticizers such as dibutyl phthalate, bis(2-ethylhexyl) phthalate, diisodecyl phthalate, dicyclohexyl phthalate, butyl benzyl phthalate, and ditridecyl phthalate will function satisfactorily as processing plasticizers. The processing oil may be a white mineral oil, such as Sonneborn Britol 50T (Sonneborn LLC (Petrolia, PA)) and/or Citgo Tufflo 6056 (Citgo Petroleum Corporation (Houston, TX)).

There are many organic extraction liquids that can be used in the process of manufacturing the microporous material. Examples of suitable organic extraction liquids include, but are not limited to, 1,1,2-trichloroethylene; perchloroethylene; 1,2-dichloroethane; 1,1,1-trichloroethane; 1,1,2-trichloroethane; methylene chloride; chloroform; 1,1,2-trichloro-1,2,2-trifluoroethane; isopropyl alcohol; diethyl ether; acetone; hexane; heptane and toluene. One or more azeotropes of halogenated hydrocarbons selected from trans-1,2-dichloroethylene, 1,1,1,2,2,3,4,5,5,5-decafluoropentane, and/or 1,1,1,3,3-pentafluorobutane also can be employed. Such materials are available commercially as VERTREL.TM. MCA (a binary azeotrope of 1,1,1,2,2,3,4,5,5,5-dihydrodecafluoropentane and trans-1,2-dichloroethylene: 62%/38%) and VERTREL.TM. CCA (a ternary azeotrope of 1,1,1,2,2,3,4,5,5,5-dihydrodecafluorpentane, 1,1,1,3,3-pentafluorbutane, and trans-1,2-dichloroethylene: 33%/28%/39%); Vertrel.TM. SDG (80-83% trans-1,2-dichloroethylene, 17-20% hydrofluorocarbon mixture) all available from MicroCare Corporation (New Britain, CT).

In the above-described process for producing the microporous material, extrusion and calendaring are facilitated when the filler carries much of the processing plasticizer. The capacity of the filler particles to absorb and hold the processing plasticizer is a function of the surface area of the filler. Therefore, the filler typically has a high surface area as discussed above. Inasmuch as it is desirable to essentially retain the filler in the microporous material substrate, the filler should be substantially insoluble in the processing plasticizer and substantially insoluble in the organic extraction liquid when microporous material substrate is produced by the above process. The residual processing plasticizer content is usually less than 15 percent by weight of the resulting microporous material and this may be reduced even further to levels such as less than 5 percent by weight, by additional extractions using the same or a different organic extraction liquid. The resulting microporous materials may be further processed depending on the desired application.

The conductive ink includes a resin and a conductive material. The conductive ink may be prepared from a mixture comprising the resin, the conductive material, and a solvent. The mixture may include at least one of: a drying additive, a plasticizer, a rheology modifier, and an adhesion promoter.

The solvent may include at least one of an aromatic compound, a ketone, an ester, an ether, and an alcohol. The solvent may solubilize the resin. The solvent may have an evaporation rate in the range of 0.005-6.3, such as 1-6.3, as compared to butyl acetate (evaporation rate =1). The solvent may be free of an amine containing compound. Examples of solvents that may be used include, but are not limited to: diethylene glycol monoethyl acetate (e.g., DE Acetate from Eastman Chemical Company (Kingsport, TN)), gamma-butyrolactone, propylene glycol monoethyl ether acetate (e.g., PM Acetate from Eastman Chemical Company (Kingsport, TN)), ethylene glycol monobutyl ether acetate (e.g., EB acetate from Eastman Chemical Company (Kingsport, TN)), 2-butoxyethanol, dibasic ester, propylene carbonate, and a heavy aromatic naphtha solvent (e.g., Aromatic 150 and/or Aromatic 200).

The resin may include a flexible or elongatable material. The resin, when applied to the substrate and coalesced (cured and/or dried) to form a coating, may be elongatable by at least 50%, such as at least 100% compared to its original length and/or width. The resin, when applied to the substrate and coalesced (cured and/or dried) to form a coating, may be elongatable by from 50-1000%, such as from 100-1000% compared to its original length and/or width.

The resin includes at least one of a rubber-containing resin (e.g., styrene butadiene rubber, methyl butadiene rubber, and the like) and a styrene-ethylene-butylene-styrene block co-polymer. The resin may further include a vinyl chloride/acrylate co-polymer. The resin may include at least one of a polystyrene, an acrylic, a polyurethane, a polyvinyl polymer, natural and/or synthetic rubber, and co-polymers thereof. The resin may include a mixture of a vinyl chloride-containing resin and a polyester. The resin may include a mixture of a vinyl chloride-containing resin and a polyester. The resin may include a halogenated polymer, chlorinated polyolefin, polyester, acrylic, rubber like polymer, and their hybrids. The polymers can be waterborne and/or solvent-borne.

Suitable commercial examples of resins for inclusion in the conductive ink include styrene based polymers, non-limited examples of which are available under the tradenames, C-FLEX^{®} (Concept Polymer Technologies, Inc. (Apple Valley, CA)), DYLENE^{®} (Nova Chemicals (Calgary, Canada)), KRATON^{®} G (Kraton Corporation (Houston, TX)), MULTIFLEX^{®} by Multibase (Dow Corning), VALTRA^{®} (Chevron Phillips Chemical), and VECTOR^{®} (Dexco Polymers (Plaquemine, LA)). Vinyl chloride copolymers such as vinyl chloride/acrylate copolymers such as VINNOL^{®} E/A grades (Wacker Polymers (Calvert City, KY)), vinyl chloride/vinyl acetate and vinyl chloride/hydroxyl modified vinyl acetate copolymers such as products available from Kunshan PG Chem Company, Ltd. (Huizhou, China).

The conductive material may include at least one of silver, gold, nickel, aluminum, copper, ferric materials, alloys, and carbon based materials (e.g., organic conductive materials, such as polyaniline (PANI) or polypyrrole, graphite/graphene, carbon nanotube types). The conductive material may include a metal flake morphology, or the conductive material may have a spherical, spear like, or tubular morphology. The conductive material may include a silver flake or a silver coated copper flake or any flake containing any of the other above described conductive materials. The conductive material may include a multi-modal distribution of conductive particles, including but not limited to a mixture of spheres and flakes, a mixture of spheres, flakes, and tubular morphologies.

Suitable examples of silver and silver coated copper conductive materials include, but are not limited to, those available from Ferro Advanced Materials (Mayfield Heights, OH), Ames Goldsmith (South Glens Falls, NY), Johnson Matthey (London, United Kingdom), Technic Inc. (Cranston, RI), and Metalor (Neuchatel, Switzerland).

The conductive material may have a D50 particle size less than 100 µm, as measured by Microtrac S3500 particle size analyzer. The conductive material may have a D50 particle size greater than 0.5 µm. The conductive material may have a D50 particle size from 0.5-100 µm, such as from 30-40 µm, from 33-37 µm, from 10-70 µm. The conductive material may have a D50 particle size less than 70 µm, such as less than 50 µm, less than 40 µm, less than 30 µm, less than 20 µm, or less than 15 µm.

The ratio of the conductive material to the resin in the conductive ink may range from 0.25:1 to 20:1, such as from 0.25:1 to 6:1, from 1:1 to 6:1, from 1:1 to 3.5:1, for example from 1.5:1 to 2.5:1.

When the conductive ink is applied over the substrate to form the electrically shielded article, the conductive material from of the conductive ink may be present in an amount of from 5 g/m² to 500 g/m², such as 7 g/m² to 500 g/m² over a surface of the substrate. When the conductive ink is applied over the substrate to form the electrically shielded article, the conductive material from of the conductive ink is present in an amount at least 5 g/m², such as at least 7 g/m² over a surface of the substrate. The conductive ink may be present over the surface of the substrate in this range over the region of the substrate over which the conductive ink is applied.

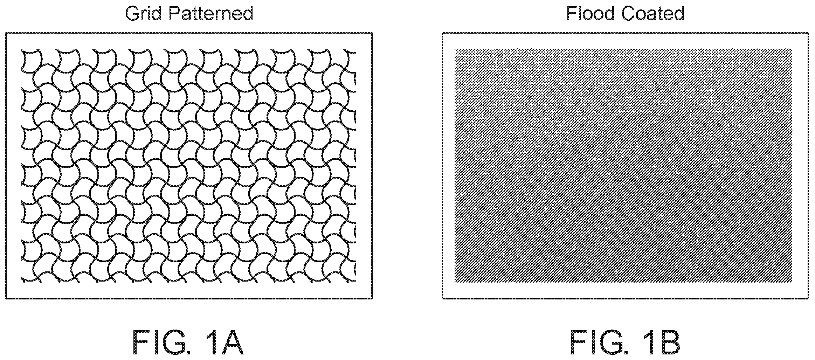

The conductive ink may be applied over the substrate in a pattern, such as a grid pattern (*see* FIG. 1A). The grid pattern may include grid lines spaced between 0.1-10 mm apart, such as from 1-3 mm apart. As used herein, grid is not limited to a network of uniformly spaced horizontal and perpendicular lines, but encompasses any network defined by any number and type of shapes. The conductive ink may be applied over the substrate as a continuous coating over a region of the substrate or over the entire substrate (*see* FIG. 1B), such as by slot die coating. Including the conductive ink over a section of the substrate allows the targeted section to be a shielded area of the substrate, while other sections of the substrate not including the conductive ink may not be shielded. The conductive ink applied over the substrate may form an electrically conductive path over the shielded portion of the substrate. The conductive ink may be applied to the substrate using an application process such as, but not limited to: screen printing, spray coating, slot die (flood) coating, gravure printing, flexo printing, ink jet printing, digital printing, and 3D printing, and combinations thereof.

The conductive ink may be applied over the substrate so as to form a film thickness of the conductive ink ranging from 0.25 mils - 5.0 mils (approximately 6.25 µm - 130 µm), such as from 0.25 mils - 2.0 mils (approximately 6.25 µm - 51 µm), such as when the conductive ink is applied via flood coating, slot die coating, spray coating or other printing/coating technique. The film thickness of the conductive ink may range from 1 µm - 20 µm, such as when the conductive ink is applied in a pattern (e.g., a grid pattern) over the substrate.

As previously described, the electrically shielded article includes the substrate and the conductive ink applied over the substrate.

When a force is applied to the electrically shielded article, the electrically shielded article may be stretchable from a first orientation having a first signal loss to a second orientation having a second signal loss. When the force is removed, the article may relax to substantially the first orientation (within 5%, such as within 1%) and substantially the first signal loss (within 5%, such as within 1%).

The electrically shielded article exhibits (in the first orientation, the second orientation, or both) a signal loss of at least 5 dBm, such as at least 10 dBm, at least 15 dBm or at least 25 dBm at up to 4 mm. Signal loss, may be determined by the following NFC Attenuation Test. The following materials were used in the NFC Attenuation Test:

| **Material** | **Quantity** |
|---|---|
| 13.56 MHz Coil | 2 |
| 12 in UFL Cable | 2 |
| Acrylic Paper Holder | 1 |
| Wooden Spacers | 4 |
| Plastic Spacers | 2 |
| Network Analyzer (Agilent 8753E) | 1 |

The UFL cables were connected to the coils. One of the UFL cables was connected to Port 1 of the network analyzer, and the other of the UFL cables was connected to Port 2 of the network analyzer. The wooden spacers were set up on either side of the acrylic paper holder. Each coil was placed in the plastic spacer on opposite sides of the acrylic paper holder, each coil 10 cm (4 inches) from the acrylic paper holder. The network analyzer was set to Sweep CW time at a frequency of 13.56 MHz and a power level of 0 dBm. The NFC Attenuation Test was then performed as follows:
1. The network analyzer was set to measure S11 and record the baseline dB value.
2. The network analyzer was then set to measure S22 and record the baseline dB value.
3. The network analyzer was then set to measure S12 and record the baseline dB value.
4. The electrically shielded article to be tested was then placed in the acrylic paper holder.
5. Steps 1-3 were repeated to record S11, S22, and S12 per electrically shielded article tested to determine a delta from the baseline reading to determine signal loss for the tested electrically shielded article.

The electrically shielded article may exhibit a detuning effect, such that the proximity of the substrate coated with the conductive ink may change the tuning characteristics (e.g., the resonance frequency or Q factor associated with the antenna) compared to the same article not including the substrate coated with the conductive ink.

Detuning effect and signal loss may be determined by the following NFC Detuning Test. The following materials were used in the NFC Detuning Test:

| **Material** | **Quantity** |
|---|---|
| 13.56 MHz Coil | 2 |
| 7 in UFL Cable | 2 |
| PVC Pipe Spacer | 1 |
| Plastic Spacers | 2 per size (22 total) |
| Network Analyzer (Agilent 8753E) | 1 |
| Ruler or meter stick | 1 |

The UFL cables were connected to the coils. An adhesive was used to attach a coil to each end of the piece of PVC pipe, cut 5 cm (2 inches) in length. Small notches were cut into the PVC pipe for the cables to rest in the notches. This assembly was placed on a flat surface with the PVC pipe in an upright position so that one coil is near top of the assembly and the other coil is at the bottom of the PVC pipe. The coil at the bottom of the assembly was connected to Port 1 on the network analyzer and the coil at the top of the PVC pipe was connected to Port 2 of the network analyzer. The network analyzer was set to sweep from 10 MHz to 25 MHz at a power of 0 dBm. The NFC Detuning Test was then performed as follows:
1. The network analyzer was set to measure S11 and record the baseline dB value at 13.56 MHz.
2. The network analyzer was then set to measure S22 and record the baseline dB value at 13.56 MHz.
3. The network analyzer was then set to measure S12 and record the baseline dB value at 13.56 MHz.
4. The electrically shielded article to be tested was then placed under the assembly (between the assembly and the flat surface).
5. Steps 1-3 were repeated to record S11, S22, and S12 per electrically shielded article tested to determine a delta from the baseline reading to determine detuning for the tested electrically shielded article for the distance from between the electrically shielded article and the assembly.
6. The network analyzer was set to measure S11, and the lowest dBm point on the frequency sweep was found, and the dBm point and frequency were recorded to determine the detuning effect and the signal loss.
7. Two 1 mm spacers were placed between the assembly and the electrically shielded article being tested.
8. Steps 5-7 were repeated for all pairs of spacers (such that detuning effect and signal loss at different distances (between 0-11 mm) between the electrically shielded article and the assembly were measured).

According to the above-described NFC Detuning Test, the electrically shielded article exhibits a (in the first orientation, the second orientation, or both) signal loss of at least 5 dBm, such as at least 10 dBm, at least 15 dBm or at least 25 dBm at 0 mm, up to 4 mm from the assembly.

The electrically shielded article may be in the form of a sheet. The electrically shielded article may be rolled in a master roll or a slit roll.

The electrically shielded article may be subjected to any number of finishing techniques, such as folding, molding, perforating, stitching, and/or gluing without substantially altering the shielding effectiveness (altered less than 5%, such as less than 1%, such as 0% compared to its unaltered state) of the electrically shielded article.

The electrically shielded article may be printable. Graphics may be applied to both coated and uncoated surfaces of the electrically shielded article by various printing techniques including, but not limited to: offset lithography, flexography, digital, inkjet, laser, intaglio, and/or gravure.

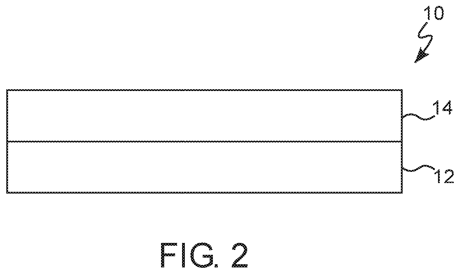

Referring to FIG. 2, an electrically shielded article 10 as described herein is shown. The electrically shielded article 10 may include a substrate 12 as described herein and a conductive ink 14 as described herein applied over at least a portion of the substrate 12.

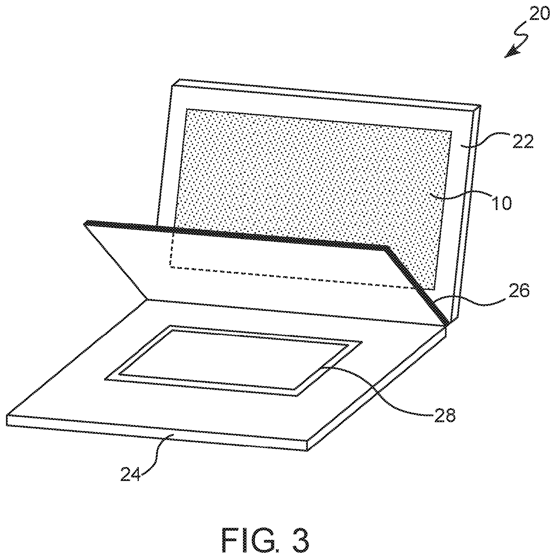

Referring to FIG. 3, an identification device 20 including the electrically shielded article 10 is shown. The identification device 20 may include a front cover 22 and a rear cover 24, and interceding e-data pages 26 between the front cover 22 and the rear cover 24. The front cover 22 may include the electrically shielded article 10, such as on an inside portion thereof. The rear cover 24 may include an antenna 28 printed thereon, such as on an inside portion thereof. The e-date pages 26 may include data relevant to the identification device 20, such as data associated with the user and/or the identity of the user. The rear cover 24 may additionally and/or alternatively include the electrically shielded article 10. The electrically shielded article 10 may shield data associated with the identification device 20 (such as stored on an RF actuated chip embedded therein) when the identification device 20 is closed (not shown) and may enable the data to be read by an receiver (e.g., an RF receiver) when the identification device 20 is opened (*see* FIG. 3).

A same page and/or cover of the identification device 20 may include both the electrically shielded article 10 and the antenna 28, or the electrically shielded article 10 and the antenna 28 may be included on separate pages and/or covers. The electrically shielded article 10 may be included on a front cover 22 of the identification device 20, the e-data page 26 of the identification device 20, another interceding page of the identification device 20, and/or a back cover 24 of the identification device 20. The identification device 20 may include a machine readable travel document (e.g., a passport), a government issued national identification card, a driver's license, a voter registration card, a birth certificate, a social security card, a health insurance card, a university identification card, an employee identification card, a university diploma, certificate, or transcript, or any other device including personally identifiable information.

The electrically shielded article may be included in a system to at least partially shield a space. The electrically shielded article may be included as tape on a package, such as a package to be shipped, to electrically shield the contents of the package. The electrically shielded article may be included as a wallpaper over a wall and/or a ceiling and/or a floor in a residence or building to shield a space (e.g., a safe room) of the residence or building. The electrically shielded article may include a pouch for an electronic payment card (e.g., debit or credit card), cell phone, and/or an electronic toll pass, a grounding tape, a circuit board, an actuated chip, an antenna, an electronic device, or any other product for which RF (or other range of electromagnetic wavelengths) protection may be beneficial.

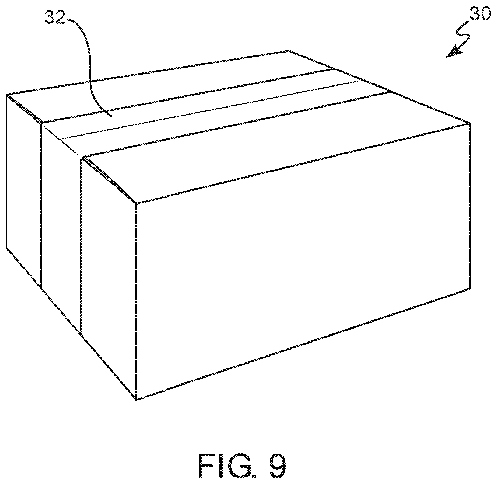

Referring to FIG. 9, an electrically shielded box 30 may include electrically shielded tape 32 as an electrically shielded article adhered over at least a portion of the electrically shielded box 30. The tape 32 may shield the contents of the box 30 from being read (e.g., electronic data stored in the box 30 from being read by a suitable receiver) with the box 30 sealed by the tape 32. The tape 32 may be applied over the entire surface of the box 30 or over select areas of the surface of the box 30. The tape 32 may be applied over at least one seam of the box 30.

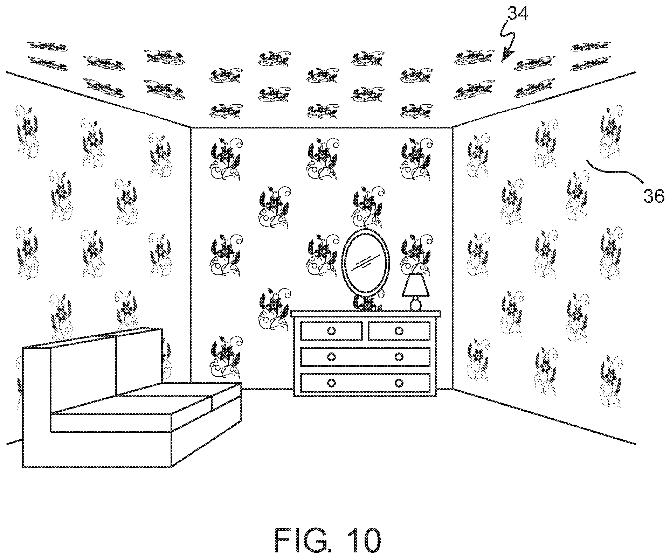

Referring to FIG. 10, an electrically shielded space 34 may include electrically shielded wallpaper 36 applied over at least a portion of the walls and/or ceiling of the electrically shielded space 34. The wallpaper 36 may shield the contents of the space 34 from being read (e.g., electronic data stored in the space 34 from being read by a suitable receiver). The wallpaper 36 may be applied over the entire surface of the space 34 or over select areas of the surface of the space 34.

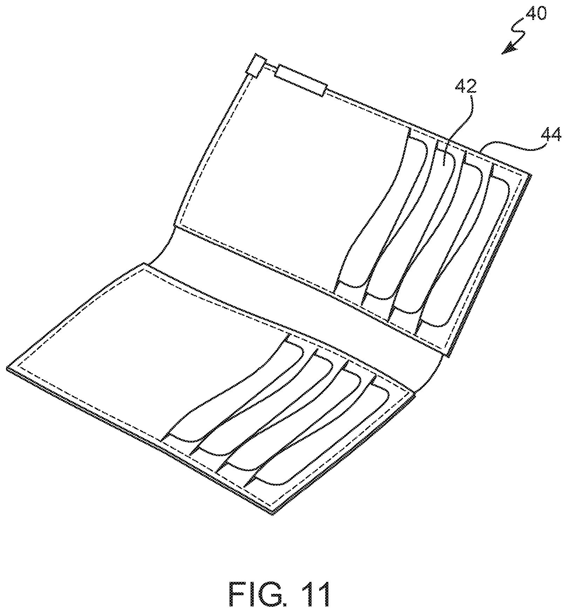

Referring to FIG. 11, an electrically shielded pouch 40 for an electronic payment card 42 may include an electrically shielding material 44. The electrically shielding material 44 may shield the contents of the electrically shielded pouch 40 (e.g., the electronic payment card 42) from being read (e.g., electronic data stored on the electronic payment card 42 from being read by a suitable receiver).

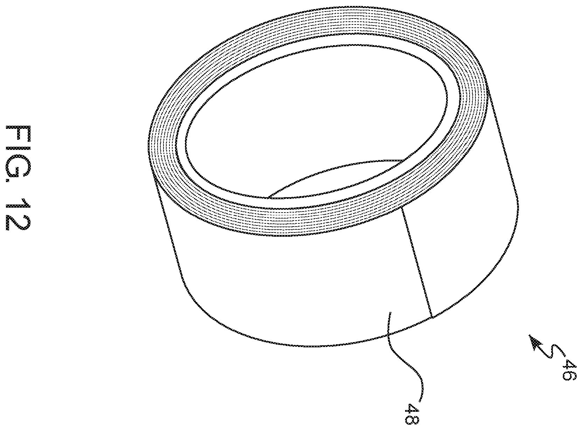

Referring to FIG. 12, a roll 46 of an electrically shielding material 48 is shown. The electrically shielding material 48 on the roll 46 may include an electrically shielding tape and/or an electrically shielding paper, which may be applied over an object desired by a user. The electrically shielding material 48 may include an adhesive configured to adhere the electrically shielding material 48 to the surface of the object.

The electrically shielded article as described herein may be prepared by applying the conductive ink to the flexible and/or elongatable substrate. When the conductive ink is applied over the substrate, the conductive material in the conductive ink is present over the substrate in an amount of at least 5 g/m². The electrically shielded article provides a signal loss of at least 5 dBm at up to 4 mm according to the NFC Detuning Test.

### EXAMPLES

The following examples are presented to demonstrate the general principles of the invention. The invention should not be considered as limited to the specific examples presented.

### Part I: Preparation of conductive inks

### Example 1: Preparation of silver conductive ink formulation (not according to the invention)

**Table 1. Ink formulation**

| Component | Parts by weight |
|---|---|
| 2-butoxyethyl acetate | 18.74 |
| PVC resin¹ | 6.25 |
| LANCO PP 1362D² | 0.35 |
| Silver pigment³ | 65.98 |
| 2-butoxyethyl acetate | 8.65 |
| Propylene Glycol Monomethyl Ether acetate | 4.69 |
| hydroquinone | 0.30 |

| | |
|---|---|
| ¹ A blend of vinyl chloride/2-hydroxypropyl acrylate copolymer with CAS# [53710-52-4]. ² A modified polypropylene wax available from The Lubrizol Corporation (Wickliffe, OH). ³ A silver flake pigment with D50 of approximately 4 µm. | |

The PVC resin was first dissolved in the first quantity of 2-butoxyethyl acetate according to Table 1 with high sheer mixing. Once the PVC was dissolved, the wax was added, followed by addition of the silver pigment under low to moderate agitation. The resulting suspension was passed through a 3 roll mill for a single pass, then the last quantity of 2-butoxyethyl acetate, propylene glycol monomethyl ether acetate and hydroquinine were added to produce the final ink composition comprising a Pigment to PVC resin ("binder") of 10.56.

### Example 2: Preparation of silver coated copper conductive ink formulation.

**Table 2. Ink formulation**

| Component | Parts by weight |
|---|---|
| Toluene | 24.79 |
| Xylene | 24.79 |
| Styrene based Resin⁴ | 8.75 |
| Silver coated coppers | 26.46 |
| Isopropyl alcohol, anhydrous | 1.62 |
| Toluene | 6.79 |
| Xylene | 6.79 |

| | |
|---|---|
| ⁴ A triblock styrene-ethylene-butylene-styrene (SEBS) linear polymer with a tri-block structure comprising approximately 29-30% styrene. ⁵ A 15% silver coated copper flake with D50 particle size of approximately 30 to 40 µm. | |

The first three ingredients in Table 2 were combined and agitated until the resin was fully dissolved. The solids were adjusted to 16% with additional toluene. The metal flake was then added slowly to avoid dust, the sides of the vessel washed down with the isopropyl alcohol. The resulting mixture was stirred at moderate agitation to incorporate the pigment. The remaining toluene and xylene were added to provide a final ink composition with a solids of 35% and a pigment to binder ratio of 3.0.

### Part II: Coating of substrate.

### Part IIa. Screen printing procedure.

The ink formulation of Example 1 was applied via a rotary screen in a roll-to-roll process. The ink formulation was delivered to the substrate by using a wiper blade to push the material through the desired grid screen at a line speed of 15 FPM. The coated material was passed through a heated oven for a total residence time of 3 minutes at 120°C to yield a screen printed substrate with a grid pattern which was then taken up in a second roll. The samples listed in Table 3 were prepared by the screen printing process. The line width for each grid was between 7-10 microns.

**Table 3. Screen printed samples.**

| Sample | Substrate⁶ | Grid size | Conductive material (g/m²) |
|---|---|---|---|
| Sample 1 | *Teslin* SP700 | 1 mm | 22 |
| Sample 2 | *Teslin* SP1400 | 1 mm | 22 |
| Sample 3 | *Teslin* SP600 | 3 mm | 7 |

| | | | |
|---|---|---|---|
| ⁶ All *Teslin*^{®} substrates were obtained from PPG Industries, Inc. (Pittsburgh, PA). | | | |

### Part IIb. Slot-die coating procedure.

The ink formula of Example 2 was added to a tank pressurized with a pad of air. The ink was pushed into a slot die and delivered to the substrate passing beneath at a rate to give the desired film thickness. The coated substrate was dried in an oven at 120°C for 2 minutes to yield a full (flood) coated substrate. The samples listed in Table 4 were prepared by the slot-die procedure:

**Table 4. Slot die coated samples**

| Sample | Substrate | Film thickness | Conductive material (g/m²) |
|---|---|---|---|
| Sample 4 | *Teslin* SP600 | 31.75 µm (1.25 mil) | 169 |
| Sample 5 | *Teslin* SP1400 | 19.05 µm (0.75 mil) | 101 |
| Sample 6 | *Teslin* SP1400 | 31.75 µm (1.25 mil) | 169 |

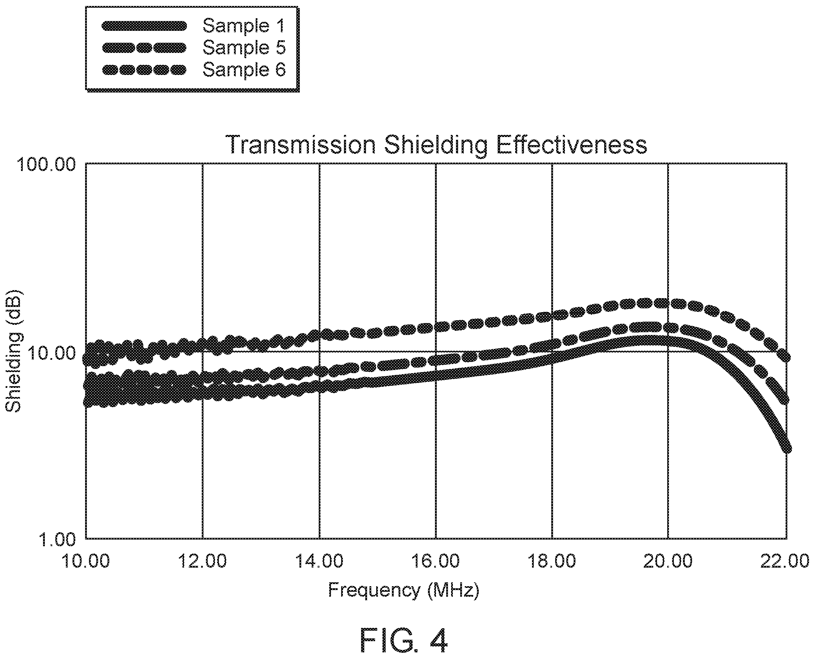

FIG. 4 shows the transmission shielding effectiveness (signal loss) for Samples 1, 5, and 6, with signal loss determined according to the NFC Attenuation Test. As can be seen from FIG. 4, the samples show a good shielding effectiveness, and different levels of shielding effectiveness can be achieved.

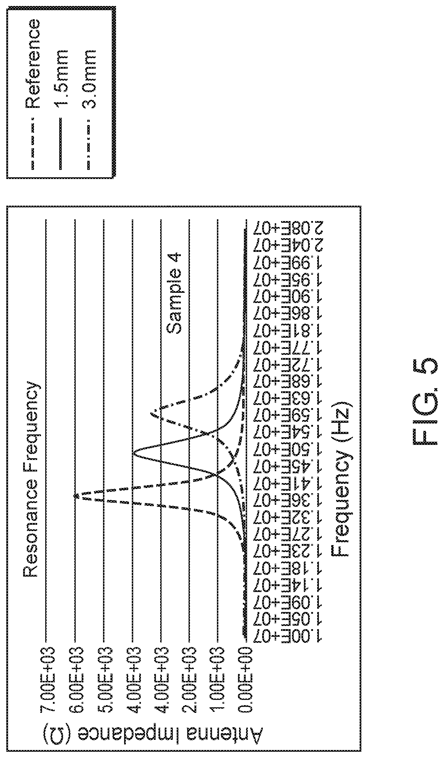

FIG. 5 shows detuning at 1.5 mm and 3.0 mm gaps (between the shielding material and the receiving antenna) for Sample 4 compared to a reference reflecting the antenna response absent any shielding material. Sample 4 was integrated into a booklet using the same cover and adhesive materials as a standard passport but did not include the passport electronics. The antenna impedance was determined according to the NFC Detuning Test. As can be seen from FIG. 5, the following beneficial results were achieved using Sample 4: (1) the resonant frequency (peak of impedance) changes drastically with the presence of the shield, (2) the impedance changes drastically with the presence of the shield, and (3) the width of the peak spreads out (also known as the q-factor). At least these factors show detuning of the antenna pair, effectively interrupting the communication.

FIGS. 6A and 6B show the signal loss at 13.56 MHz and detuned resonance frequency, respectively, as a function of distance for Samples 2 and 6 with the booklet open compared to a control copper. Signal loss and detuned resonance frequency were determined according to the NFC Detuning Test. As can be seen from FIGS. 6A and 6B, all three samples provide essentially the same level of signal blocking and detuning.

Tables 5 and 6 below show certain properties associated with the control (unshielded *Teslin* SP1400) compared to Samples 5 and 6.

**Table 5. Elongation and Tensile Strength**

| | **Machine Direction** | | **Cross Direction** | |
|---|---|---|---|---|
| **Sample** | **Elongation** | **Tensile Strength** | **Elongation** | **Tensile Strength** |
| **Control** | 100% | 100% | 100% | 100% |
| **Sample 5** | 113% | 126% | 109% | 133% |
| **Sample 6** | 110% | 121% | 105% | 125% |

Elongation and tensile strength are both increased for Samples 5 and 6 compared to the control sample. Tensile strength in Samples 5-6 increased by 20-30%. Machine direction elongation and cross direction elongation were determined using an Instron Universal Testing Machine model 3343 or 3345, manufactured by Instron (Norwood, MA).

**Table 6. Thermal Shrink, Stiffness, Tear Resistance**

| **Sample** | **Thermal Shrink (MD)** | **Stiffness (HOM)** | **Tear Resistance** |
|---|---|---|---|
| **Control** | 100% | 100% | 100% |
| **Sample 5** | 72% | 141% | 130% |
| **Sample 6** | 67% | 184% | 119% |

Stiffness for Samples 5 and 6 increased compared to the control sample by 40-85%. Tear resistance for Samples 5 and 6 increased compared to the control sample by 15-30%. Thermal shrinkage for Samples 5 and 6 decreased compared to the control sample by approximately 30%. Stiffness was measured using the Handle-O-Meter model 211-300, manufactured by Thwing Albert Company (Philadelphia, PA). Tear resistance was measured using an Elemendorf Tearing Tester, Model 60-2001, manufactured by Thwing Albert Company (Philadelphia, PA).

Thermal shrink was measured by cutting the sample in the machine direction or cross direction, such that the sheet has a length of 355.5 mm. The cut sheet was placed in an oven preheated to 135°C between two pre-heated stainless steel sheets and left in the oven for 15 minutes. The samples were removed from the oven, separated, and left to cool for 5 minutes. A ruler was used to measure the length of the sheet (in millimeters) to determine percent shrinkage.

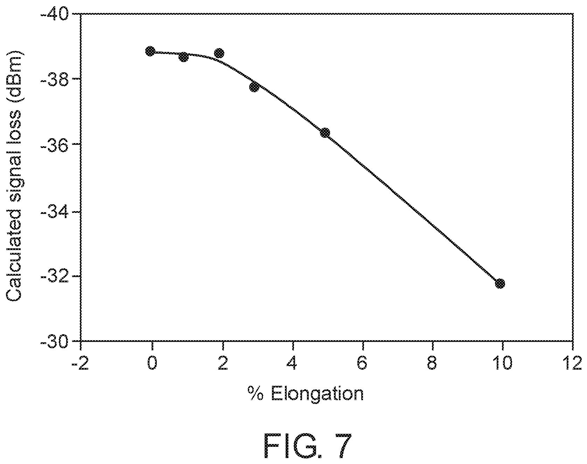

For Sample 4, signal loss as a function of % elongation was calculated. Signal loss was calculated by assuming a linear relationship between resistance (measured as described hereinafter) and signal loss obtained by fitting resistance v. signal loss from the tests done in connection with FIG. 6A. FIG. 7 shows these results. As can be seen from FIG. 7, Sample 4 maintained a high degree of shielding efficiency even when elongated.

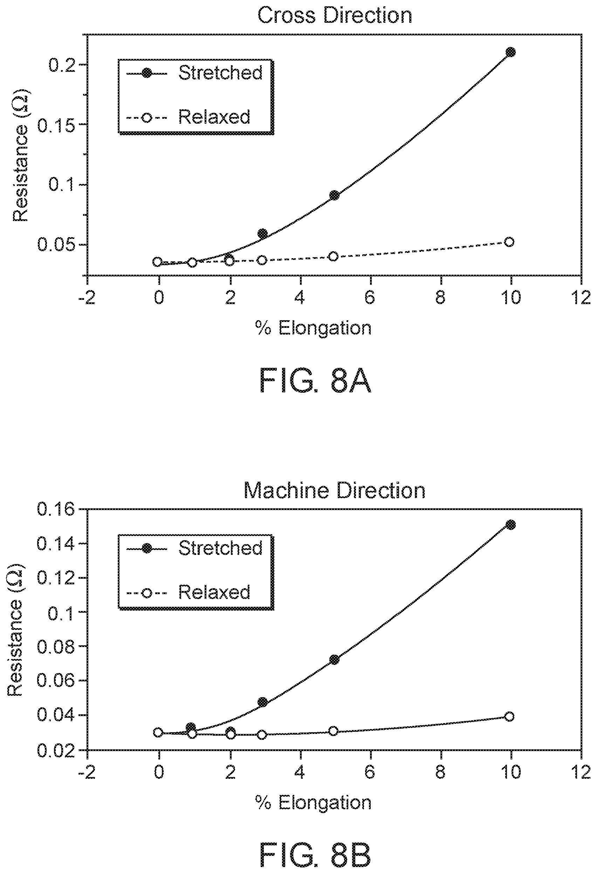

For Sample 4, resistance was measured using a four point probe as a function of % elongation was measured in the cross direction (FIG. 8A) and machine direction (FIG. 8B). As can be seen from FIGS. 8A and 8B, the shielding material in Sample 4 could be stretched and retain significant conductivity. Upon relaxation, the shielding material in Sample 4 returned close to the baseline shielding efficiency. A minimal change in resistance occurred beyond 2% elongation. In these graphs, resistance was measured with a Keithley 2450 Sourcemeter when the material was stressed (stretched) to the noted elongation and then allowed to relax to the previous state over 24 hours, at which time resistance was measured again.

Whereas particular embodiments of this invention have been described above for purposes of illustration, it will be evident to those skilled in the art that numerous variations of the details of the present invention may be made without departing from the invention as defined in the appended claims.

## Claims

1. An electrically shielded article, comprising:
a flexible and/or elongatable substrate comprising a polyolefin; and
a conductive ink applied over at least a portion of the substrate, the conductive ink comprising a resin and a conductive material, wherein the resin comprises at least one of a rubber-containing resin and a styrene-ethylene-butylene-styrene block co-polymer,
wherein when the conductive ink is applied over the substrate, the conductive material in the conductive ink is present over the substrate in an amount of at least 5 g/m²,
wherein the electrically shielded article exhibits a signal loss of at least 5 dBm at up to 4 mm according to the NFC Detuning Test.

2. The electrically shielded article of claim 1, wherein when the conductive ink is applied over the substrate to form the electrically shielded article, the conductive material from of the conductive ink is present in an amount of from 5 g/m² to 500 g/m² over a surface of the substrate.

3. The electrically shielded article of claim 1, wherein the conductive ink is prepared from a mixture comprising the resin, the conductive material, and a solvent
wherein the solvent preferably comprises at least one of an aromatic compound, a ketone, an ester, and an alcohol, or
wherein the solvent is free of an amine containing compound.

4. The electrically shielded article of claim 1, wherein a ratio of the conductive material to the resin in the conductive ink is from 0.25:1 to 6:1,
preferably from 1.5:1 to 2.5:1.

5. The electrically shielded article of claim 1, wherein the conductive material comprises at least one of silver, gold, nickel, aluminum, copper, ferric materials, alloys, and carbon based materials, or wherein the conductive material has a D50 particle size from 0.5 µm to 100 µm.

6. The electrically shielded article of claim 1, wherein the substrate is elongatable by at least 50%.

7. The electrically shielded article of claim 1, wherein the substrate comprise pores,
wherein the substrate preferably comprises a filler,
wherein the filler preferably comprises a siliceous material.

8. The electrically shielded article of claim 1, wherein the conductive ink is applied to the substrate using at least one of the following application processes: screen printing, spray coating, slot die coating, gravure printing, flexo printing, ink jet printing, digital printing, and 3D printing, or
wherein the conductive ink is applied over the substrate in a pattern,
or wherein the conductive ink is applied over the substrate as a continuous coating over a region of the substrate.

9. The electrically shielded article of claim 1, wherein, when a force is applied to the electrically shielded article, the electrically shielded article is stretchable from a first orientation having a first signal loss to a second orientation having a second signal loss,
wherein when the force is removed, the electrically shielded article preferably relaxes to substantially the first orientation and substantially the first signal loss.

10. A method of preparing an electrically shielded article, comprising:
applying a conductive ink to a flexible and/or elongatable substrate comprising a polyolefin,
wherein the conductive ink comprises a resin and a conductive material, wherein the resin comprises at least one of a rubber-containing resin and a styrene-ethylene-butylene-styrene block co-polymer,
wherein when the conductive ink is applied over the substrate, the conductive material in the conductive ink is present over the substrate in an amount of at least 5 g/m²,
wherein the electrically shielded article provides a signal loss of at least 5 dBm at up to 4 mm according to the NFC Detuning Test.

11. The method of claim 10, wherein the conductive ink is applied to the substrate using at least one of the following application processes: screen printing, spray coating, slot die printing, gravure printing, flexo printing, ink jet printing, digital printing, and 3D printing.

12. An identification device, comprising the electrically shielded article of claim 1.

13. The identification device of claim 12, wherein the identification device comprises a machine readable travel document, or
comprising:
a first page comprising the electrically shielded article; and
a second page comprising an antenna.

## Patentansprüche

1. Ein elektrisch abgeschirmter Gegenstand umfassend:
ein flexibles und/oder dehnbares Substrat, das ein Polyolefin umfasst, und
eine leitfähige Tinte, die auf wenigstens einem Teil des Substrats aufgebracht ist, wobei die leitfähige Tinte ein Harz und ein leitfähiges Material umfasst, wobei das Harz wenigstens eines von einem kautschukhaltigen Harz und einem Styrol-Ethylen-Butylen-Styrol-Blockcopolymer umfasst,
wobei, wenn die leitfähige Tinte auf das Substrat aufgetragen wird, das leitfähige Material in der leitfähigen Tinte in einer Menge von wenigstens 5 g/m² über dem Substrat vorhanden ist,
wobei der elektrisch abgeschirmte Gegenstand einen Signalverlust von wenigstens 5 dBm bei bis zu 4 mm gemäß dem NFC-Detuning-Test aufweist.

2. Der elektrisch abgeschirmte Gegenstand des Anspruchs 1, wobei, wenn die leitfähige Tinte über dem Substrat aufgebracht wird, um den elektrisch abgeschirmten Gegenstand zu bilden, das elektrisch leitfähige Material von der leitfähigen Tinte in einer Menge von 5 g/m² bis 500 g/m² über einer Oberfläche des Substrats vorhanden ist.

3. Der elektrisch abgeschirmte Gegenstand des Anspruchs 1, wobei die leitfähige Tinte aus einer Mischung umfassend das Harz, das leitfähige Material und ein Lösungsmittel hergestellt ist,
wobei das Lösungsmittel vorzugsweise wenigstens eines von einer aromatischen Verbindung, einem Keton, einem Ester und einem Alkohol umfasst, oder
wobei das Lösungsmittel frei von einer aminhaltigen Verbindung ist.

4. Der elektrisch abgeschirmte Gegenstand des Anspruchs 1, wobei ein Verhältnis von dem leitfähigen Material zu dem Harz in der leitfähigen Tinte von 0,25:1 bis 6:1, vorzugsweise von 1,5:1 bis 2,5:1, beträgt.

5. Der elektrisch abgeschirmte Gegenstand des Anspruchs 1, wobei das leitfähige Material wenigstens eines von Silber, Gold, Nickel, Aluminium, Kupfer, Materialien mit dreiwertigem Eisen, Legierungen und kohlenstoffbasierten Materialien umfasst, oder
wobei das leitfähige Material eine D50-Partikelgröße von 0,5 µm bis 100 µm aufweist.

6. Der elektrisch abgeschirmte Gegenstand des Anspruchs 1, wobei das Substrat um wenigstens 50% dehnbar ist.

7. Der elektrisch abgeschirmte Gegenstand des Anspruchs 1, wobei das Substrat Poren umfasst,
wobei das Substrat vorzugsweise einen Füllstoff umfasst,
wobei der Füllstoff vorzugsweise ein kieselsäurehaltiges Material umfasst.

8. Der elektrisch abgeschirmte Gegenstand des Anspruchs 1, wobei die leitfähige Tinte unter Verwendung von wenigstens einem der folgenden Anwendungsverfahren auf das Substrat aufgebracht wird:
Siebdruck, Sprühbeschichten, Schlitzdüsenbeschichten, Tiefdruck, Flexodruck, Tintenstrahldruck, Digitaldruck und 3D-Druck, oder
wobei die leitfähige Tinte über dem Substrat in einem Muster aufgebracht ist,
oder wobei die leitfähige Tinte über dem Substrat als eine durchgehende Beschichtung über einem Bereich des Substrats aufgebracht ist.

9. Der elektrisch abgeschirmte Gegenstand des Anspruchs 1, wobei, wenn eine Kraft auf den elektrisch abgeschirmten Gegenstand appliziert wird, der elektrisch abgeschirmte Gegenstand von einer ersten Orientierung aufweisend einen ersten Signalverlust zu einer zweiten Orientierung aufweisend einen zweiten Signalverlust dehnbar ist,
wobei, wenn die Kraft entfernt wird, der elektrisch abgeschirmte Gegenstand vorzugsweise im Wesentlichen zu der ersten Orientierung und im Wesentlichen zu dem ersten Signalverlust relaxiert.

10. Ein Verfahren zum Herstellen eines elektrisch abgeschirmten Gegenstands umfassend:
Aufbringen einer leitfähigen Tinte auf ein flexibles und/oder dehnbares Substrat, umfassend ein Polyolefin,
wobei die leitfähige Tinte ein Harz und ein leitfähiges Material umfasst,
wobei das Harz wenigstens eines von einem kautschukhaltigen Harz und einem Styrol-Ethylen-Butylen-Styrol-Blockcopolymer umfasst,
wobei, wenn die leitfähige Tinte über dem Substrat aufgebracht ist, das leitfähige Material in der leitfähigen Tinte über dem Substrat in einer Menge von wenigstens 5 g/m² vorhanden ist,
wobei der elektrisch abgeschirmte Gegenstand einen Signalverlust von wenigstens 5 dBm bei bis zu 4 mm gemäß dem NFC-Detuning-Test aufweist.

11. Das Verfahren des Anspruchs 10, wobei die leitfähige Tinte auf das Substrat unter Verwendung wenigstens eines der folgenden Anwendungsverfahren aufgebracht wird:
Siebdruck, Sprühbeschichten, Schlitzdüsenbeschichten, Tiefdruck, Flexodruck, Tintenstrahldruck, Digitaldruck und 3D-Druck.

12. Eine Identifikationsvorrichtung umfassend den elektrisch abgeschirmten Gegenstand nach Anspruch 1.

13. Die Identifikationsvorrichtung des Anspruchs 12, wobei die Identifikationsvorrichtung ein maschinenlesbares Reisedokument umfasst, oder umfassend:
eine erste Seite umfassend den elektrisch abgeschirmten Gegenstand, und eine zweite Seite umfassend eine Antenne.

## Revendications

1. Article blindé électriquement comprenant :
un substrat souple et/ou étirable comprenant une polyoléfine ; et
une encre conductrice appliquée au moins sur une partie du substrat, l'encre conductrice comprenant une résine et un matériau conducteur, dans lequel la résine comprend au moins un élément parmi une résine contenant du caoutchouc et un copolymère à blocs styrène-éthylène-butylène-styrène,
dans lequel lorsque l'encre conductrice est appliquée sur le substrat, le matériau conducteur de l'encre conductrice est présent sur le substrat en une quantité d'au moins 5 g/m²,
dans lequel l'article blindé électriquement présente une perte de signal d'au moins 5 dBm jusqu'à 4 mm selon le Test de Désaccord CCP.

2. Article blindé électriquement selon la revendication 1, dans lequel lorsque l'encre conductrice est appliquée sur le substrat pour former l'article blindé électriquement, le matériau conducteur de l'encre conductrice est présent en une quantité de 5 g/m² à 500 g/m² sur une surface du substrat.

3. Article blindé électriquement selon la revendication 1, dans lequel l'encre conductrice est préparée à partir d'un mélange comprenant la résine, le matériau conducteur et un solvant ;
dans lequel le solvant comprend de préférence au moins un élément parmi un composé aromatique, une cétone, un ester et un alcool, ou
dans lequel le solvant est exempt de composé contenant une amine.

4. Article blindé électriquement selon la revendication 1, dans lequel un rapport entre le matériau conducteur et la résine dans l'encre conductrice vaut de 0,25/1 à 6/1, de préférence de 1,5/1 à 2,5/1.

5. Article blindé électriquement selon la revendication 1, dans lequel le matériau conducteur comprend au moins un élément parmi l'argent, l'or, le nickel, l'aluminium, le cuivre, les matériaux ferriques, les alliages et les matériaux à base de carbone, ou dans lequel le matériau conducteur a une taille de particules D50 de 0,5 µm à 100 µm.

6. Article blindé électriquement selon la revendication 1, dans lequel le substrat est étirable d'au moins 50 %.

7. Article blindé électriquement selon la revendication 1, dans lequel le substrat comprend des pores,
dans lequel le substrat comprend de préférence une charge,
dans lequel la charge comprend de préférence un matériau siliceux.

8. Article blindé électriquement selon la revendication 1, dans lequel l'encre conductrice est appliquée sur le substrat en utilisant au moins l'un des procédés d'application suivants : la sérigraphie, le revêtement par pulvérisation, le revêtement par filière plate, l'héliogravure, l'impression flexographique, l'impression par jet d'encre, l'impression numérique et l'impression 3D, ou
dans lequel l'encre conductrice est appliquée sur le substrat selon un motif,
ou dans lequel l'encre conductrice est appliquée sur le substrat sous la forme d'un revêtement continu sur une région du substrat.

9. Article blindé électriquement selon la revendication 1, dans lequel, quand on applique une force à l'article blindé électriquement, l'article blindé électriquement peut être étiré d'une première orientation ayant une première perte de signal à une deuxième orientation ayant une deuxième perte de signal,
dans lequel, quand on supprime la force, l'article blindé électriquement se relâche de préférence pour reprendre la première orientation et substantiellement la première perte de signal.

10. Procédé de préparation d'un article blindé électriquement, comprenant les étapes suivantes :
appliquer une encre conductrice sur un substrat souple et/ou étirable comprenant une polyoléfine,
dans lequel l'encre conductrice comprend une résine et un matériau conducteur, dans lequel la résine comprend au moins un élément parmi une résine contenant du caoutchouc et un copolymère à blocs styrène -éthylène -butylène- styrène,
dans lequel lorsque l'encre conductrice est appliquée sur le substrat, le matériau conducteur de l'encre conductrice est présent sur le substrat en une quantité d'au moins 5 g/m²,
dans lequel l'article blindé électriquement fournit une perte de signal d'au moins 5 dBm jusqu'à 4 mm selon le Test de Désaccord CCP.

11. Procédé selon la revendication 10, dans lequel l'encre conductrice est appliquée sur le substrat en utilisant au moins l'un des procédés d'application suivants : la sérigraphie, le revêtement par pulvérisation, l'impression par filière plate, l'héliogravure, l'impression flexographique, l'impression par jet d'encre, l'impression numérique et l'impression 3D.

12. Dispositif d'identification comprenant l'article blindé électriquement selon la revendication 1.

13. Dispositif d'identification selon la revendication 12, dans lequel le dispositif d'identification comprend un document de voyage lisible par machine, ou
comprenant:
une première page comprenant l'article blindé électriquement ; et
une deuxième page comprenant une antenne.
